# EUROPEAN PATENT SPECIFICATION

(11) **EP 2 317 657 B1**
(45) Date of publication and mention of the grant of the patent: **01.06.2016**
(21) Application number: 09766809.9
(22) Date of filing: 16.06.2009
(51) Int. Cl.: H03M 13/27, H04L 27/34, H04L 1/00, H03M 13/11

(54) **APPARATUS FOR ADAPTABLE/VARIABLE TYPE MODULATION AND DEMODULATION IN DIGITAL TX/RX SYSTEM**
VORRICHTUNG ZUR ANPASSBAREN/VARIABLEN MODULATION UND DEMODULATION IN DIGITALEN TX/RX-SYSTEMEN
APPAREIL DE MODULATION ET DÉMODULATION DE TYPE VARIABLE/ADAPTABLE DANS UN SYSTÈME TX/RX NUMÉRIQUE

(30) Priority: 16.06.2008 US 61709 P; 30.06.2008 US 76735 P; 07.04.2009 KR 20090029793; 12.06.2009 KR 20090052207
(43) Date of publication of application: 04.05.2011
(73) Proprietor: Electronics and Telecommunications Research Institute, Daejeon 305-700 (KR)
(72) Inventor: KIM, Sung-Hoon, Daejeon 305-700 (KR); LEE, Eung Don, Daejeon 305-700 (KR); CHOI, Jin Soo, Daejeon 305-700 (KR); HONG, Jin Woo, Daejeon 305-700 (KR); AHN, Chung Hyun, Daejeon 305-700 (KR); KIM, Chang-Joong, Seoul 100-451 (KR); LEE, Kyoung-Hweon, Seoul 110-540 (KR); LEE, Ho-Kyoung, Goyang-si Gyeonggi-do 410-350 (KR)
(74) Representative: Betten & Resch
(86) International application number: PCT/KR2009/003198
(87) International publication number: WO 2009/154384

(56) References cited:
- EP-A2- 1 182 816
- WO-A1-00/17752
- WO-A1-2008/069492
- US-A1- 2006 224 934
- US-A1- 2007 098 110
- US-A1- 2007 118 787
- US-A1- 2007 143 654
- MAYER A ET AL: "Analytical and Experimental IP Encapsulation Efficiency Comparison of GSE, MPE, and ULE over DVB-S2", SATELLITE AND SPACE COMMUNICATIONS, 2007. IWSSC '07. INTERNATIONA L WORKSHOP ON, IEEE, PI, 1 September 2007 (2007-09-01), pages 114-118, XP031194873, DOI: 10.1109/IWSSC.2007.4409401 ISBN: 978-1-4244-0938-9

## Description

### Technical Field

The present invention relates to an adaptable/variable type modulation and demodulation apparatus, and more particularly, to an adaptable/variable type modulation and demodulation apparatus in a transmission/reception system that applies a forward error correction (FEC) scheme to an application layer and uses a low density parity check (LDPC) error correction scheme on partial data in a physical layer, to perform modulation and demodulation.

### Background Art

Currently used digital cable transmission systems include a US-based digital cable transmission system, namely DOCSIS/OpenCable, that is based on single carrier 64/256-quadrature amplitude modulation (QAM) type modulation/demodulation using a Reed-Solomon/trellis coded modulation (RS/TCM) error correction code, and also a European-based digital cable transmission system, namely digital video broadcasting-cable (DVB-C), that is based on a 64/256-QAM type modulation/demodulation using an RS error correction code.

However, new transmission standards for next generation broadcasting, such as a low density parity check (LDPC) error correction code and the like, offer a 30 percent increase in a data transmission amount while in an additive white Gaussian noise (AWGN) environment compared with a conventional method.

Accordingly, a 1024/4096-QAM modulation/demodulation scheme which is considered high-dimensional when compared with a 64/256-QAM type modulation/demodulation scheme used in the conventional transmission method has been proposed. However, distortion of a received signal due to a fading channel environment is still a problem preventing wide-spread use of the high-dimensional modulation/demodulation scheme.

Also, a main requirement of the next generation transmission system is that application of a constellation/forward error correction (FEC) variable coding rate in an RF physical layer based on a channel status is applied to a transmission system of each medium.

However, a solution for the problem which introduces an adaptable type modulation/demodulation in an RF physical layer has a low flexibility.

Accordingly, a method of introducing an error correction code in an application layer that has a high flexibility and is advantageous in embodiment/cost is required.

US 2007/143654 A1 relates to a method and apparatus for using long FEC codes in a content distribution system, particularly to encoding frames of content. Each frame is partitioned into un-coded bits and bits to be encoded. For each frame, an FEC code is applied to the bits to be encoded to generate a codeword. Groups of bits from the codeword are divided among a plurality of channels. Symbols formed from the groups of bits and the un-coded bits are mapped to a constellation for each of the plurality of channels. The symbols are modulated across a respective plurality of bonded channels for transmission.

US 2006/224934 A1 relates to a system for correcting random and/or burst errors using RS (Reed-Solomon) code, turbo/LDPC (Low Density Parity Check) code and convolutional interleave and discloses to combine different coding types within a communication system to perform various types of error correction. This combination of accommodating different coding types may be employed at either end of a communication channel (e.g., at a transmitter end when performing encoding and/or at a receiver end when performing decoding). By combining different coding types within a communication system, the error correcting capabilities of the overall system is significantly improved. The appropriate combination of turbo code and/or LDPC code along with RS code allows for error correction or various error types including random error and burst error (or impulse noise).

### Disclosure of Invention

### Technical Goals

An aspect of the present invention provides an adaptable/variable type modulation/demodulation apparatus in a digital transmission/reception system.

Another aspect of the present invention also provides an adaptable/variable type modulation/demodulation apparatus in a digital transmission/reception system where a forward error correction (FEC) scheme is applied to an application layer.

Another aspect of the present invention also provides an adaptable/variable type modulation/demodulation apparatus in a digital transmission/reception system where the digital transmission/reception system performs modulation/demodulation of data, and the data determines a coset in a physical layer using LEPC.

Another aspect of the present invention also provides an adaptable/variable type modulation/demodulation apparatus in a digital transmission/reception system that applies an FEC scheme to an application layer and performs modulation/demodulation of partial data in a physical layer using LDPC.

### Technical solutions

The present invention is defined in the independent claims. The dependent claims define embodiments of the present invention.

A physical layer transmission apparatus for adaptable/variable type modulation, includes a classification unit to classify a bit stream into a bit stream to be low density parity check (LDPC)-coded and a bit stream not to be LDPC-coded according to a predetermined scheme, when receiving the bit stream, an uncoded bit group unit to group the bit stream not to be LDPC-coded by a predetermined number of bits to output the uncoded bit groups, an LDPC encoder to perform LDPC-coding of the bit stream to be LDPC-coded to output the coded bit stream, a coded bit group unit to group the coded bit stream by the predetermined number of bits to output the coded bit groups, a quadrature amplitude modulation (QAM) unit to select a symbol coset by using the coded bit groups and to determine a symbol from the selected symbol coset by using the uncoded bit groups, and a convolutional interleaver to perform convolutional interleaving of the symbol determined by the quadrature amplitude modulation unit.

A physical layer reception apparatus for adaptable/variable type demodulation, includes a convolutional deinterleaver to output a soft decision uncoded bit group and a soft decision coded bit group by convolutional deinterleaving a received signal, an LDPC decoder to perform LDPC-decoding of the soft decision coded bit group to output a decoded bit group, an LDPC encoder to perform LDPC-coding of the decoded bit group to output a coded bit group, a symbol coset search unit to select a symbol coset by using the coded bit group, a symbol search unit to select a symbol from the selected symbol coset that the symbol coset search unit selects, by using the soft decision uncoded bit group, an uncoded bit extracting unit to extract an uncoded bit group from the symbol selected through the symbol search unit, and a bit combining unit to combine the decoded bit group and the uncoded bit group to generate a bit stream.

An application layer transmission apparatus, includes a forward error correction (FEC) code inserting unit to insert, to received robust data, an FEC code for error correction, an error detection code inserting unit to insert, to the robust data where the FEC code is inserted, an error detection code to detect whether the error exists, and a frame multiplexing unit to receive and multiplex normal data and the robust data where the FEC code and the error detection code are inserted and to output the multiplexed data to a physical layer.

A application layer reception apparatus, includes a frame demultiplexing unit to output data by classifying a normal data and robust data when receiving a data stream from a physical layer, an error detecting unit to detect whether an error exists by checking an error detection code included in the robust, and an error correction unit to correct an error by checking an FEC code included in the robust data, when the error detected by the error detecting unit.

### Advantageous Eflect.

The present invention relates to an adaptable/variable type modulation/demodulation apparatus in a cable transmission/reception system that applies an FEC scheme to an application layer and performs modulation/demodulation of data that determines coset in a physical layer, using an LDPC scheme. The modulation/demodulation is performed using the LDPC scheme only on the data that determines the coset, thereby providing adaptable and variable modulation/demodulation. Also, the error correction is possible based on the LDPC scheme, thereby enabling a large amount of information to be transmitted in a limited bandwidth and increasing a transmission rate. Also, an efficiency of channel equalization occurring in a high-dimensional modulation/demodulation is improved using a training sequence.

### Brief Description of Drawings

FIG 1 is a diagram illustrating a configuration of an application layer transmission apparatus for forward error correction (FEC) coding according to an embodiment of the present invention;
FIG. 2 is a diagram illustrating a configuration of an application layer reception apparatus for FEC decoding according to an embodiment of the present invention;
FIG. 3 is a diagram illustrating a configuration of a physical layer transmission apparatus including an adaptable/variable type modulation apparatus according to an embodiment of the present invention;
FIG. 4 is a diagram illustrating a configuration of a physical layer reception apparatus including an adaptable/variable type demodulation apparatus according to an embodiment of the present invention; and
FIG. 5 is a diagram illustrating another configuration of an application layer transmission apparatus for FEC coding according to an embodiment of the present invention.

### Best Mode for Carrying Out the Invention

Although a few exemplary embodiments of the present invention have been shown and described, the present invention is not limited to the described exemplary embodiments, wherein like reference numerals refer to the like elements throughout.

The present invention relates to an adaptable/variable type modulation/demodulation apparatus in a digital transmission/reception system that applies a forward error correction (FEC) scheme to an application layer and performs modulation/demodulation of data that determines a coset in a physical layer using a low density parity check (LDPC) code/scheme. In this instance, examples of the digital transmission/reception system include a digital cable transmission/reception system, a digital multimedia broadcasting (DMB) system, a satellite DMB system, and an Internet Protocol television (IPTV) system, and the like.

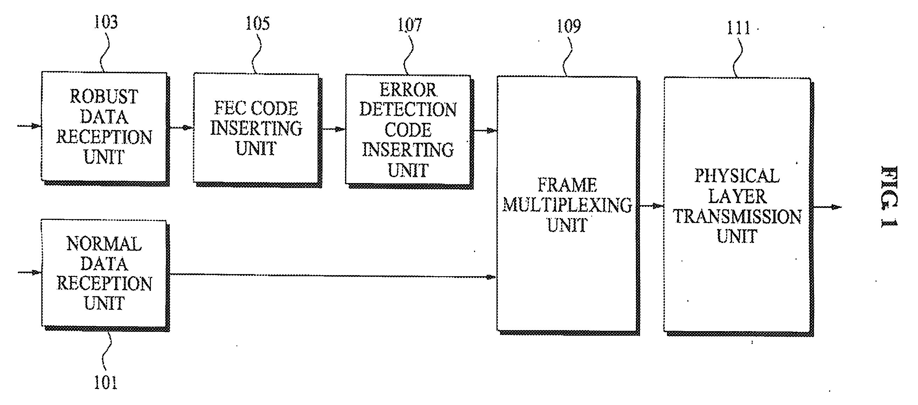

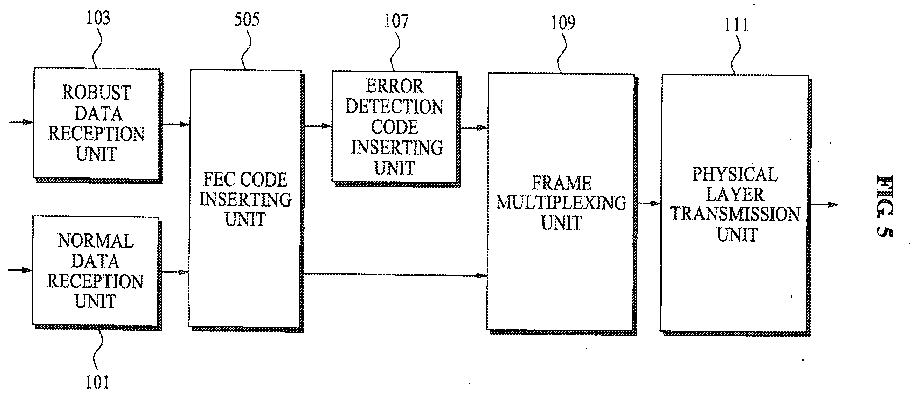

FIG 1 is a diagram illustrating a configuration of an application layer transmission apparatus for FEC coding according to an embodiment of the present invention. FIG. 5 is a diagram illustrating another configuration of an application layer transmission apparatus for FEC coding according to an embodiment of the present invention.

Referring to FIG. 1, the application layer transmission apparatus includes a normal data reception unit 101, a robust data reception unit 103, a forward error correction (FEC) code inserting unit 105, an error detection code inserting unit 107, a frame multiplexing unit 109, and a physical layer transmission unit 111.

The robust data reception unit 103 receives robust data that is data to be coded being robust with respect to error, the robust data including cost data, charged data, and important data, and provides the received robust data to the FEC code inserting unit 105. In this instance, the robust data includes robust identification information used for identifying robust data.

The normal data reception unit 101 receives normal data that is not classified as robust data, and provides the received normal data to the frame multiplexing unit 109.

The FEC code inserting unit 105 inserts an FEC code for error correction to the received robust data, and outputs the robust data where the FEC code is inserted to the detection code inserting unit 107. Also, an FEC code inserting unit 505 of FIG. 5 may insert an FEC code of normal data or a parity bit of the normal data in addition to the FEC code of the robust data.

The error detection code inserting unit 107 inserts an error detection code for error detection, to the robust data where the FEC code is inserted. In this instance, the error detection code inserting unit 107 inserts the error detection code instead of a Moving Pictures Experts Group-transport stream (MPEG-TS) sync byte that is typically included in a TS packet, when the robust data where the FEC code is inserted is constituted by an MPEG-TS packet. Here, the MPEG-TS sync byte is information used for determining whether synchronization is achieved. An MPEG-TS packet is constituted by 188 bytes where the first four bytes are header information and the remaining 184 bytes are data information. The first byte of the header information is a sync byte having a value of '0 x 47' and is utilized when a reception unit identifies a beginning of a new MPEG-TS 188 byte. Accordingly, the first byte of the header of the MPEG-TS packet is referred to as the sync byte.

The frame multiplexing unit 109 receives the robust data from the error detection code inserting unit 107, the robust data including the FEC code and the error detection code, receives the normal data from the normal data reception unit 101, and multiplexes the received robust data and the normal data to output to the physical layer transmission unit 111.

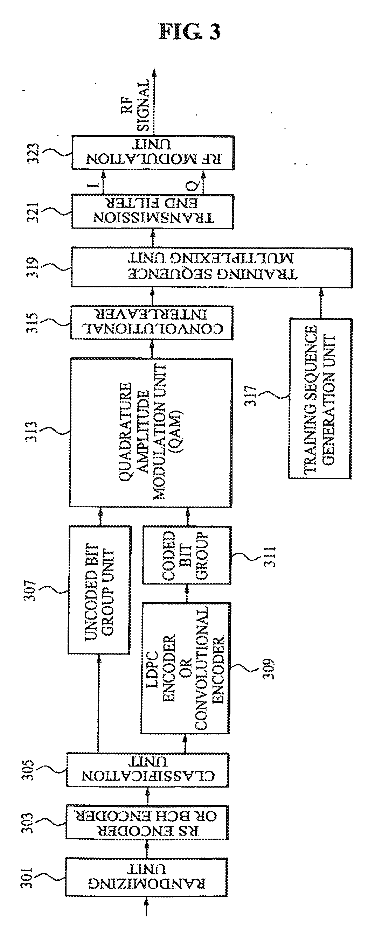

The physical layer transmission unit 111 performs adaptable/variable type modulation of the received multiplexed data stream to output a generated RF signal. Detailed description for the physical layer transmission unit 111 will be disclosed with reference to FIG. 3.

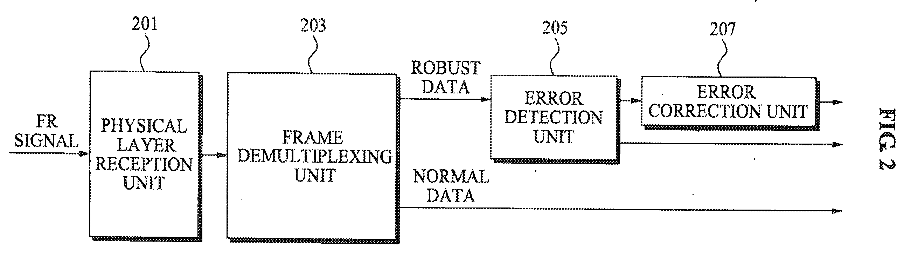

FIG. 2 is a diagram illustrating a configuration of an application layer reception apparatus for FEC decoding according to an embodiment of the present invention.

Referring to FIG. 2, the application layer reception apparatus includes a physical layer reception unit 201, a frame demultiplexing unit 203, an error detection unit 205, and an error correction unit 207.

The physical layer reception unit 201 receives an RF signal, performs adaptable/variable demodulation of the received RF signal, and outputs a data stream to the frame demultiplexing unit 203.

When receiving the data stream from the physical layer reception unit 201, the frame demultiplexing unit 203 classifies the received data stream into normal data and robust data using robust data identification information of the received data stream. Next, the frame demultiplexing unit 203 outputs the normal data as is and outputs the robust data to the error detection unit 205.

when receiving the robust data from the frame demultiplexing unit 203, the error detection unit 205 uses an error detection code included in the robust data to detect whether an error exists. When an error is not detected, the robust data is outputted as is, and when an error is detected, the error detection unit 205 outputs the robust data to the error correction unit 207. In this instance, according to the present invention, when the robust data is constituted by an MPEG-TS packet, the error detection code is included in a header of the MPEG-TS packet including an MPEG-TS sync byte.

Also, when the error detection unit 205 identifies that either an FEC code or a parity bit, the FEC code and the parity bit being of the normal data and the normal data being received together with the robust data, is added to the robust data, and the error detection unit 205 either outputs data indicating existence/absence of an error in the normal data or provides the FEC code of the normal data to the error correction unit 207 to correct the error, using either the added FEC code of the normal data or the parity bit of the normal data.

When the error is detected as a result of the detection of the error detection unit 205, the error correction unit 207 checks the FEC code included in the robust data, and outputs the robust data after correcting the error when error correction is possible.

FIG. 3 is a diagram illustrating a configuration of a physical layer transmission apparatus including an adaptable/variable type modulation apparatus according to an embodiment of the present invention.

FIG. 3 illustrates a detailed configuration of the physical layer transmission apparatus 111 of FIG 1, the physical layer transmission apparatus 111 including a randomizing unit 301, a Reed-Solomon (RS) or Bose-Chaudhuri-Hocquenghen (BCH) encoder 303, a classification unit 305, an uncoded bit group unit 307, a low density parity check (LDPC) encoder or convolutional encoder 309, coded bit group unit 311, a quadrature amplitude modulation unit (QAM) 313, a convolutional interleaver 315, a training sequence symbol generation unit 317, a training sequence multiplexing unit 319, a transmission end filter 321, and a radio frequency (RF) modulation unit 323.

When receiving an input signal, the randomizing unit 301 randomizes the received input signal using a pseudo random binary sequence (PRBS) equation and outputs the randomized signal to the RS or BCH encoder 303. The RS or BCH encoder 303 is a device for inserting an error correction code, and is able to provide an RS code scheme or BCH code scheme. The error correction code is inserted to recover from an error occurring in a high signal to noise ratio (SNR) before performing LDPC, coding.

The classification unit 305 receives an output of the RS or BCH encoder 303 and classifies the received output into either a bit stream to be LDPC-coded or a bit stream not to be LDPC-coded depending on a standard that is determined in advance with the physical layer reception unit 201. The uncoded bit group unit 307 groups the bit stream not to be LDPC-coded by a predetermined number of bits and outputs the uncoded bit groups to the QAM 313.

The LDPC encoder 309 performs LDPC-coding of the bit stream to be coded and outputs the coded bit stream to the coded bit group unit 311. In this instance, the LDPC encoder 309 may be replaced with the convolutional encoder 309. In a case of using the convolutional encoder 309, the convolutional encoder 309 performs convolutional coding of the bit stream to be coded and outputs the coded bit stream to the coded bit group unit 311.

The coded bit group unit 311 groups the coded bit streams by a predetermined number of bits and outputs the coded bit groups to the QAM 313. The QAM 313 selects a symbol coset using the coded bit groups, determines a symbol from the selected symbol coset using the uncoded bit groups, and outputs the selected symbol to the convolutional interleaver 315. The convolutional interleaver 315 performs convolutional interleaving of the symbol received from the QAM 313.

The training sequence symbol generation unit 317 outputs a predetermined training sequence symbol to the training multiplexing unit 319. The training multiplexing unit 319 outputs the convolutional interleaved symbol while the convolutional interleaved symbol is received, for channel equalization, and outputs the training sequence symbol to the transmission end filter 321 when the convolutional interleaved symbol is no longer received. Also, the training symbol generation unit 317 determines whether to insert the training sequence by signaling with the physical layer reception apparatus, and transmits the training sequence variably depending on the determination.

The transmission end filter 321 is a filter used for eliminating a transmission bandwidth limitation and intersymbol interference (ISI), and filters outputs of the training stream multiplexing unit 319 to provide the filtered outputs to the RF modulation unit 323. The transmission filter 321 may perform root raised cosine filtering. The RF modulation unit 323 performs RF modulation of the signal received from the transmission end filter 321, and outputs the RF modulated signal.

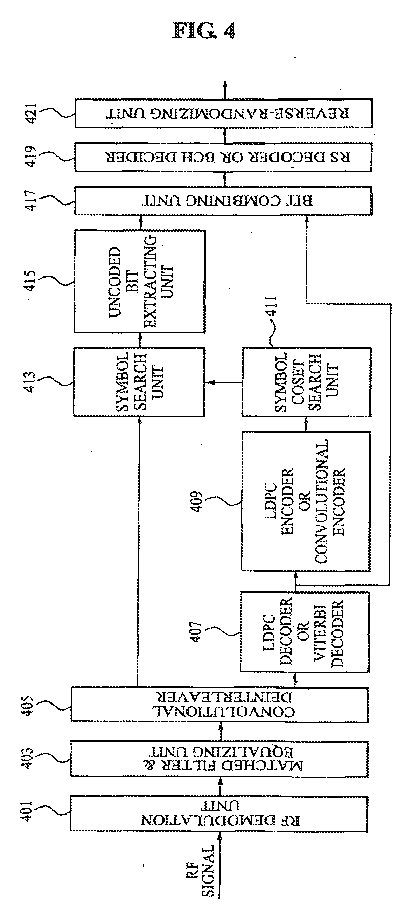

FIG. 4 is a diagram illustrating a configuration of a physical layer reception apparatus including an adaptable/variable type demodulation apparatus according to an embodiment of the present invention.

FIG 4 illustrates a detailed configuration of the physical layer reception apparatus 201 of FIG 2, the physical layer reception apparatus 201 including an RF demodulation unit 401, a matched filter & equalizing unit 403, a convolutional deinterleaver 405, an LDPC decoder or Viterbi decoder 407, an LDPC encoder or a convolutional encoder 409, a symbol coset search unit 413, a symbol search unit 415, an uncoded bit extracting unit 415, a bit combining unit 417, an RS or BCH decoder 419, and a reverse-randomizing unit 421.

The RF demodulation unit 401 performs demodulation of an RF signal and outputs the demodulated RF signal to the matched filter & equalizing unit 403. The matched filter & equalizing unit 403 performs filtering of the demodulated signal, performs channel-equalizing of the filtered signal based on a predetermined training sequence, and outputs the channel-equalized signal to the convolutional deinterleaver 405.

The equalizing unit of the matched filter & equalizing unit 403 checks whether to insert the training sequence by signaling with a physical layer transmission apparatus, and, depending on the result of the determination, variably receives the training sequence. That is, the equalizing unit performs channel-equalizing using the training sequence only when the training sequence is inserted.

The convolutional deinterleaver 405 outputs a soft decision uncoded bit group and a soft decision coded bit group by convolutional deinterleaving a received channel-equalized signal. The convolutional deinterleaver 405 generates an output bit of a predetermined location to be outputted, to the LDPC decoder 407, as the soft decision uncoded bit group and an output bit of a remaining location to be outputted, to the symbol search unit 415, as the soft decision coded bit group.

When receiving the soft decision coded bit group from the convolutional deinterleaver 405, the LDPC decoder 407 performs LDPC-decoding of the soft decision coded bit group, and outputs the decoded bit group to the LDPC encoder 409 and to the bit combining unit 417. The LDPC encoder 409 performs LDPC-coding of the decoded bit group received from the LDPC decoder 407 and outputs, to the symbol coset search unit 413, the coded bit group of which error is corrected.

Also, in this instance, the LDPC decoder 407 may be replaced with a Viterbi decoder 407. In a case of using the Viterbi decoder 407, the Viterbi decoder 407 performs Viterbi decoding of the soft decision coded bit group and outputs the decoded bit group to the bit combining unit 417 and to the convolutional encoder 409. In this instance, the convolutional encoder 409 may be used as a substitution for the LDPC encoder 409.

Also, the LDPC decoder 407 is able to perform error detection and error correction by a bit unit when performing decoding, and also able to obtain error information in a packet unit. Accordingly, the LDPC decoder 407 performs error detection by a packet unit and provides the error detection information to the application layer reception apparatus when the error detection inserting unit 107 is not applicable in the application layer transmission apparatus. The error detection information is included in the first four bytes of the 188 bytes of a header of an MPEG-TS packet.

Subsequently, the convolutional encoder 409 performs convolutional encoding of the decoded bit group received from the Viterbi decoder 407, and outputs the convolutional encoded group as a coded bit group of which error is corrected for the symbol coset search unit 411.

The symbol coset search unit 411 selects a symbol coset using the coded bit group received from the LDPC encoder 409 and outputs the selected symbol coset to the symbol search unit 413. The symbol search unit 413 selects a symbol from the selected symbol coset received from the symbol coset search unit 411, using the soft decision uncoded bit group received from the convolutional deinterleaver 405, and outputs the selected symbol to the uncoded bit extracting unit 415.

The uncoded bit extracting unit 415 extracts the uncoded bit group from the selected symbol received from the symbol search unit 413 and outputs the extracted uncoded bit group to the bit combining unit 417. The bit combining unit 417 combines the uncoded bit group received from the uncoded bit extracting unit 415 and the decoded bit group received from the LDPC decoder 407 to generate a bit stream, and outputs the generated bit stream to the RS or BCH decoder 419.

The RS or BCH decoder 419 performs RS decoding or BCH decoding of the received bit stream according to a used code scheme, and outputs the decoded bit stream to the reverse-randomizing unit 421.

also, the RS or BCH decoder 419 is able to perform error detection and error correction by a bit unit when performing decoding, and is able to obtain error detection information in a packet unit.

Accordingly, the RS or BCH decoder 419 performs error detection in a packet unit and provides the error detection information to the application layer reception apparatus when the error detection inserting unit 107 is not suitable for the physical layer transmission apparatus. The error detection information is included in the first four bytes of 188 bytes, namely a header of an MPEG-TS packet.

Also, example of devices performing error detection by a packet unit may include all decoders where FEC is suitable, in addition to the LDPC decoder 407 and the RS or BCH decoder 419.

When receiving the decoded bit stream from the RS or BCH decoder 419, the reverse-randomizing unit 421 performs reverse-randomizing of the received decoded bit stream. The reverse-randomizing unit 421 restores the randomized signal to an original signal, the restoring being a reverse operation of the randomizing performed in the randomizing unit of FIG. 301.

Although embodiments of the present invention have been shown and described the physical layer and application layer transmission/reception apparatus in a digital transmission/reception system with respect to FIGS. 1 through 4, the present invention is also applicable to a territorial wave transmission/reception system, a satellite signal transmission/reception system, and an IPTV system, in addition to the digital transmission/reception system.

Although a few embodiments of the present invention have been shown and described, the present invention is not limited to the described embodiments. Instead, it would be appreciated by those skilled in the art that changes may be made to these embodiments without departing from the principles of the invention, the scope of which is defined by the claims and their equivalents.

## Claims

1. A physical layer transmission apparatus (111) for adaptable/variable type modulation, the apparatus (111) comprising:
a classification unit (305) to classify a bit stream into a bit stream to be low density parity check, LDPC, -coded and a bit stream not to be LDPC-coded according to a predetermined scheme, when receiving the bit stream;
an uncoded bit group unit (307) to group the bit stream not to be LDPC-coded by a predetermined number of bits and to output uncoded bit groups;
a LDPC encoder (309) to perform LDPC-coding of the bit stream to be LDPC-coded and to output a coded bit stream;
a coded bit group unit (311) to group the coded bit stream by the predetermined number of bits and to output coded bit groups;
a quadrature amplitude modulation, QAM, unit (313) to select a symbol coset by using the coded bit groups and to determine a symbol from the selected symbol coset by using the uncoded bit groups; and
a convolutional interleaver (315) to perform convolutional interleaving of the symbol determined by the quadrature amplitude modulation unit (313).

2. The apparatus (111) of claim 1, further comprising:
a training sequence generation unit (317) to output a predetermined training sequence symbol; and
a training sequence multiplexing unit (319) to output a convolutional interleaved symbol while the convolutional interleaved symbol is received, and to output the training sequence symbol when the convolutional interleaved symbol is no longer received.

3. A physical layer reception apparatus (201) for adaptable/variable type demodulation, the apparatus comprising:
a convolutional deinterleaver (405) to output a soft decision uncoded bit group and a soft decision coded bit group by convolutional deinterleaving a received signal;
a LDPC decoder (407) to perform LDPC-decoding of the soft decision coded bit group and to output a decoded bit group;
a LDPC encoder (409) to perform LDPC-coding of the decoded bit group and to output a coded bit group;
a symbol coset search unit (411) to select a symbol coset by using the coded bit group;
a symbol search unit (413) to select a symbol from the selected symbol coset that the symbol coset search unit (411) selects, by using the soft decision uncoded bit group;
an uncoded bit extracting unit (415) to extract an uncoded bit group from the symbol selected through the symbol search unit (413); and
a bit combining unit (417) to combine the decoded bit group and the uncoded bit group to generate a bit stream.

4. The apparatus (201) of claim 3, further comprising an equalizing unit (403) to perform channel-equalizing of the received signal based on a predetermined training sequence and to transmit the channel-equalized signal to the convolutional deinterleaver (405).

## Patentansprüche

1. Vorrichtung zur Übertragung auf physikalischer Schicht (111) zur Modulation nach anpassbarer/variabler Art, wobei die Vorrichtung (111) umfasst:
eine Klassifikationseinheit (305) zum Klassifizieren eines Bitstroms in einen mittels Low-Density-Parity-Check, LDPC, zu codierenden Bitstrom und einen nicht mittels LDPC zu codierenden Bitstrom in Übereinstimmung mit einem vorbestimmten Schema, wenn der Bitstrom empfangen wird;
eine Einheit für Gruppen uncodierter Bits (307) zum Gruppieren des nicht mittels LDPC zu codierenden Bitstroms durch eine vorbestimmte Zahl von Bits und Ausgeben von Gruppen uncodierter Bits;
einen LDPC-Codierer (309) zum Durchführen von LDPC-Codierung des mittels LDPC zu codierenden Bitstroms und Ausgeben eines codierten Bitstroms;
eine Einheit für Gruppieren codierter Bits (311) zum Gruppieren des codierten Bitstroms durch die vorbestimmte Zahl von Bits und Ausgeben von Gruppen codierter Bits;
eine Quadraturamplitudenmodulations, QAM, -einheit (313) zum Auswählen einer Symbolrestklasse unter Verwendung der Gruppen codierter Bits und Bestimmen eines Symbols aus der ausgewählten Symbolrestklasse unter Verwendung der Gruppen uncodierter Bits; und
einen Konvolutionsverschränker (315) zum Durchführen von Konvolutionsverschränkung des durch die Quadraturamplitudenmoudlationseinheit (313) bestimmten Symbols.

2. Vorrichtung (111) nach Anspruch 1, ferner umfassend:
eine Trainingssequenz-Erzeugungseinheit (317) zum Ausgeben eines vorbestimmten Trainingssequenz-Symbol; und
eine Trainingssequenz-Multiplexeinheit (319) zum Ausgeben eines konvolutionsverschränkten Symbols, während das konvolutionsverschränkte Symbol empfangen wird, und Ausgeben des Trainingssequenz-Symbol, wenn das konvolutionsverschränkte Symbol nicht mehr empfangen wird.

3. Vorrichtung zum Empfang auf physikalischer Schicht (201) zur Demodulation nach anpassbarer/variabler Art, wobei die Vorrichtung umfasst:
einen Konvolutionsentverschränker (405) zum Ausgeben einer Gruppe von Soft-Decision uncodierten Bits und einer Gruppe von Soft-Decision codierten Bits durch Konvolutionsentverschränkung eines empfangenen Signals;
einen LDPC-Decoder (407) zum Durchführen von LDPC-Decodierung der Gruppe von Soft-Decision codierten Bits und Ausgeben einer Gruppe decodierter Bits;
einen LDPC-Codierer(409) zum Durchführen von LDPC-Codierung der Gruppe decodierter Bits und Ausgeben einer Gruppe codierter Bits;
eine Symbolrestklassen-Sucheinheit (411) zum Auswählen einer Symbolrestklasse unter Verwendung der Gruppe codierter Bits;
eine Symbol-Sucheinheit (413) zum Auswählen eines Symbols aus der ausgewählten Symbolrestklasse, welche die Symbolrestklassen-Sucheinheit (411) ausgewählt hat, unter Verwendung der Gruppe von Soft-Decision uncodierten Bits;
eine Einheit zum Extrahieren uncodierter Bits (415) zum Extrahieren einer Gruppe uncodierter Bits aus dem Symbol, welches durch die Symbol-Sucheinheit (413) ausgewählt ist; und
eine Bitkombinierungseinheit (417) zum Kombinieren der Gruppe decodierter Bits und der Gruppe uncodierter Bits, um einen Bitstrom zu erzeugen.

4. Vorrichtung (201) nach Anspruch 3, ferner umfassend eine Angleichungseinheit (403) zum Durchführen von Kanalangleichung des empfangenen Signals basierend auf einer vorbestimmten Trainingssequenz und Übertragen des kanalangeglichenen Signals an den Konvolutionsentverschränker (405).

## Revendications

1. Appareil de transmission de couche physique (111) pour une modulation de type adaptable/variable, l'appareil (111) comprenant :
une unité de classification (305) pour classifier un train de bits en un train de bits devant être codé par contrôle de parité à faible densité, LDPC, et un train de bits ne devant pas être codé LDPC selon un schéma prédéterminé, lors de la réception du train de bits ;
une unité de groupe de bits non codé (307) pour grouper le train de bits ne devant pas être codé LDPC par un nombre prédéterminé de bits et pour sortir des groupes de bits non codés ;
un encodeur LDPC (309) pour effectuer un codage LDPC du train de bits devant être codé LDPC et pour sortir un train de bits codé ;
une unité de groupe de bits codé (311) pour grouper le train de bits codé par le nombre prédéterminé de bits et pour sortir des groupes de bits codés ;
une unité de modulation d'amplitude en quadrature, QAM, (313) pour sélectionner un co-ensemble de symboles en utilisant les groupe de bits codés et pour déterminer un symbole à partir du co-ensemble de symboles sélectionné en utilisant les groupes de bits non codés ; et
un entrelaceur convolutif (315) pour effectuer un entrelacement convolutif du symbole déterminé par l'unité de modulation d'amplitude en quadrature (313).

2. Appareil (111) selon la revendication 1, comprenant en outre :
une unité de génération de séquence d'apprentissage (317) pour sortir un symbole de séquence d'apprentissage prédéterminé ; et
une unité de multiplexage de séquence d'apprentissage (319) pour sortir un symbole entrelacé convolutif tandis que le symbole entrelacé convolutif est reçu, et pour sortir le symbole de séquence d'apprentissage lorsque le symbole entrelacé convolutif n'est plus reçu.

3. Appareil de réception de couche physique (201) pour une démodulation de type adaptable/variable, l'appareil comprenant :
un désentrelaceur convolutif (405) pour sortir un groupe de bits non codé à décision douce et un groupe de bits codé à décision douce par le désentrelacement convolutif d'un signal reçu ;
un décodeur LDPC (407) pour effectuer un décodage LDPC du groupe de bits codé à décision douce et pour sortir un groupe de bits décodé ;
un encodeur LDPC (409) pour effectuer un codage LDPC du groupe de bits décodé et pour sortir un groupe de bits codé ;
une unité de recherche de co-ensemble de symboles (411) pour sélectionner un co-ensemble de symboles en utilisant le groupe de bits codé ;
une unité de recherche de symbole (413) pour sélectionner un symbole parmi le co-ensemble de symboles sélectionné que l'unité de recherche de co-ensemble de symboles (411) sélectionne, en utilisant le groupe de bits non codé à décision douce ;
une unité d'extraction de bit non codé (415) pour extraire un groupe de bits non codé du symbole sélectionné par le biais de l'unité de recherche de symbole (413) ; et
une unité de combinaison de bits (417) pour combiner le groupe de bits décodé et le groupe de bits non codé afin de générer un train de bits.

4. Appareil (201) selon la revendication 3, comprenant en outre une unité d'égalisation (403) pour effectuer une égalisation de canal du signal reçu sur la base d'une séquence d'apprentissage prédéterminée et pour transmettre le signal à canal égalisé au désentrelaceur convolutif (405).
